(19) Europäisches Patentamt

European Patent Office

Office européen des brevets

(11) EP 0 656 691 B1

(12) **EUROPÄISCHE PATENTSCHRIFT**

(45) Veröffentlichungstag und Bekanntmachung des Hinweises auf die Patenterteilung:
**18.03.1998 Patentblatt 1998/12**

(51) Int Cl.6: **H03K 21/02**, H03K 21/10, H03K 23/50

(21) Anmeldenummer: **94118024.2**

(22) Anmeldetag: **15.11.1994**

(54) **Schaltungsanordnung zur Erzeugung eines symmetrischen Ausgangstaktsignals**

Circuit device for providing a symmetrical output clock signal

Dispositif pour obtenir une horloge de sortie symétrique

(84) Benannte Vertragsstaaten:
**DE FR GB IT**

(30) Priorität: **01.12.1993 DE 4340966**

(43) Veröffentlichungstag der Anmeldung:
**07.06.1995 Patentblatt 1995/23**

(73) Patentinhaber: **SIEMENS AKTIENGESELLSCHAFT**
**80333 München (DE)**

(72) Erfinder:
• **Donig, Günter**
  **D-85586 Poing (DE)**
• **Götz, Edmund**
  **D-85221 Dachau (DE)**
• **Herrmann, Helmut**
  **D-81667 München (DE)**

(56) Entgegenhaltungen:
FR-A- 2 699 767　　　　GB-A- 2 259 620
US-A- 3 902 125

• **PATENT ABSTRACTS OF JAPAN vol. 6 no. 91 (E-109) [969] ,28.Mai 1982 & JP-A-57 026930 (FUJITSU K.K.) 13.Februar 1982,**
• **EDN ELECTRICAL DESIGN NEWS, Bd. 31, Nr. 2, Januar 1986 NEWTON, MASSACHUSETTS US, Seite 212 IRWIN COHEN 'divider produces symmetrical output'**

## Beschreibung

Die Erfindung betrifft eine Schaltungsanordnung zur Erzeugung eines symmetrischen Ausgangstaktsignals bei ungerader Teilung n eines symmetrischen Taktsignals.

Allgemein werden in vielen Systemen symmetrische Takte benötigt, wie z. B. bei der oberwellenarmen Takterzeugung in Hochfrequenzsystemen in Mischern, Modulatoren, Demodulatoren usw.. Bei der Teilung mit ungeradem Teilerfaktor N=3, 5, 7, 9... erzeugen übliche Teilerschaltungen im allgemeinen Ausgangstakte mit unsymmetrischem Tastverhältnis TV:

$$\text{Tastverhältnis TV} = \frac{t_L}{t_H} = \frac{1}{2}, \frac{2}{3}, \frac{3}{4}, \frac{4}{5}, \ldots .$$

Allgemein läßt sich das Tastverhältnis TV durch

$$TV = \frac{N^2 + N}{N^2 - N}, \text{ wobei } N = 3,5,7,9,\ldots$$

beschreiben.

Aus dem Stand der Technik GB 2259620 A ist ein Frequenzteiler mit ungeradem Teilungsfaktor zur Erzeugung eines Rechtecksignals bekannt. Das Signal mit dem gewünschten Tastverhältnis wird dadurch erzeugt, daß ein gegenüber dem Eingangssignal phasenverschobenes Signal vorgesehen ist. Das phasenverschobene Signal wird mit dem Eingangssignal durch ein Logikgatter verknüpft.

Aufgabe der vorliegenden Erfindung ist es eine Schaltungsanordnung zur Erzeugung eines symmetrischen Ausgangstaktsignals bei ungerader Teilung eines symmetrischen Eingangtaktsignals anzugeben.

Diese Aufgabe wird durch den kennzeichnenden Teil des Anspruchs 1 gelöst.

Prinzip der vorliegenden Erfindung ist es, der im allgemeinen längeren "Low"-Phase von z. B. zwei Taktdauern, bei einer Teilung durch 3, eine halbe Taktdauer, abzuziehen und der kürzeren "High"-Phase von z. B. einer Taktdauer, bei einer Teilung durch 3, eine halbe Taktdauer anzufügen.

Hierzu dienen erste Mittel zur Erzeugung eines ersten Ausgangssignals aus dem symmetrischen Taktsignal. Dieses Ausgangssignal wird jeweils mit der n-ten Flanke von einem ersten Typ, z. B. der steigenden Flanke, des symmetrischen Taktsignals aktiv und bleibt dies für die Dauer von $\frac{N-1}{2}$ Perioden des symmetrsichen Taktsignals. Zweite Mittel dienen zur Erzeugung eines zweiten Ausgangssignals aus dem symmetrischen Taktsignal, wobei dieses Ausgangssignal jeweils mit der n-ten Flanke vom anderen Typ, z. B. der fallenden, des symmetrischen Taktsignals aktiv wird und dies ebenfalls für die Dauer von $\frac{N-1}{2}$ Perioden des symmetrischen Taktsignals bleibt. Eine Logikanordnung verknüpft dann beide Ausgangssignale zu einem symmetrischen Ausgangssignal. Ist der aktive Zustand des ersten und zweiten Ausgangssignals jeweils "High", so kann die Logikanordnung aus einem ODER-Gatter bestehen bzw. aus einem UND-Gatter, wenn der aktive Zustand der Ausgangssignale "Low" ist.

Die Erfindung wird nachfolgend anhand von zwei Figuren näher erläutert. Es zeigen:

Figur 1     ein Ausführungsbeispiel der erfindungsgemäßen Anordnung,

Figur 2     ein Zeitdiagramm verschiedener Signale der in Figur 1 gezeigten Schaltung.

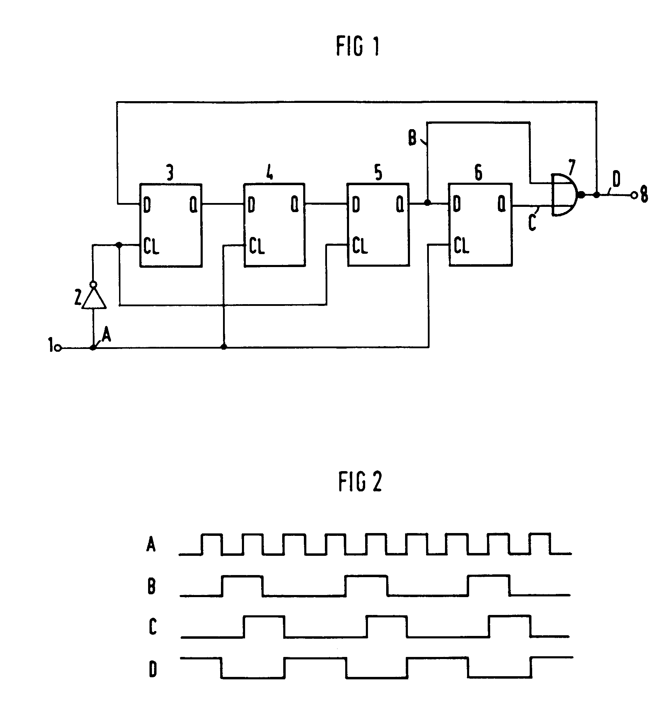

In Figur 1 ist eine erfindungsgemäße Ausführungsform eines symmetrischen Dreierteilers dargestellt. Mit 1 ist eine Eingangsklemme bezeichnet, an der das symmetrische Taktsignal zuführbar ist. Diese Eingangsklemme 1 ist jeweils mit dem Takteingang eines D-Latches 4 und 6 verbunden. Des weiteren ist sie über einen Inverter 2 mit dem Takteingang von jeweils einem weiteren D-Latches 3 und 5 verbunden. Der Ausgang Q des D-Latches 3 ist mit dem Eingang D des D-Latches 4 verschaltet. Ebenso ist der Ausgang Q des D-Latches 4 mit dem Eingang D des D-Latches 5 und der Ausgang Q des D-Latches 5 mit dem Eingang D des D-Latches 6 verbunden. Der Ausgang Q des D-Latches 5 ist mit dem ersten Eingang eines NOR-Gatters 7 verschaltet. Der zweite Eingang des NOR-Gatters 7 ist mit dem Ausgang Q des D-Latch 6 verbunden. Der Ausgang des NOR-Gatters 7 ist zum einen mit dem Eingang D des D-Latches 3 und zum anderen mit einer anderen Ausgangsklemme 8 verbunden. Die Buchstaben A, B, C, E bezeichnen Schaltungspunkte, an denen der in Figur 2 dargestellten Signalverläufe abgegriffen sind.

Die in Figur 1 dargestellte Schaltung besteht aus einzelnen D-Latches, wobei zwei wiederum ein Master-Slave-Flip-Flop bilden. Die Verzögerung von einer halben Taktperiode läßt sich durch den Abgriff zwischen Master und Slave, d. h. zwischen den D-Latches 5, 6 erzeugen. Die in Figur 1 gezeigte Schaltung hat gleichzeitig den Vorteil, daß sie automatisch auf das feste interne Taktverhältnis $T_H = 1 \cdot T$ und $T_L = 2 \cdot T$ synchronisiert und somit eine NOR-Verknüpfung, verwendet werden kann.

Wie in Figur 2 zu sehen ist, wird am Ausgang B des D-Latches 5 ein Ausgangssignal erzeugt, das mit der fallenden Flanke des an der Eingangsklemme 1 anliegenden symmetrischen Taktsignals A aktiviert wird und für die Dauer einer Taktperiode aktiv bleibt. Dieses Signal wird im Abstand von drei Taktperioden generiert. Am Ausgang C des D-Latches 6 ist das gegenüber B erzeugte Ausgangssignal um eine halbe Taktperiode versetzt. Durch die NOR-Verknüpfung wird am Knoten D ein symmetrisches Ausgangssignal erzeugt. Dieses ist am Ausgang 8 abgreifbar.

**Patentansprüche**

1. Schaltungsanordnung zur Erzeugung eines symmetrischen Ausgangstaktsignals bei ungerader Teilung N eines symmetrischen Eingangstaktsignals

   - mit einem ersten Mittel zur Erzeugung eines ersten Ausgangssignals aus dem symmetrischen Eingangstaktsignal, das mit jeweils der N-ten Flanke vom ersten Typ des symmetrischen Taktsignals beginnt und für die Dauer von $\frac{N-1}{2}$ Perioden des symmetrischen Taktsignals aktiv bleibt.
   - mit einem zweiten Mittel zur Erzeugung eines zweiten Ausgangssignals aus dem symmetrischen Taktsignal, das mit jeweils der N-ten Flanke vom anderen Typ des symmetrischen Taktsignals beginnt und für die Dauer von $\frac{N-1}{2}$ Perioden des symmetrischen Taktsignals aktiv bleibt,
   - mit einer Logikanordnung, die die beiden Ausgangssignale zu einem symmetrischen Ausgangstaktsignal verknüpft,

   **dadurch gekennzeichnet,** daß

   - N+1 in Reihe geschaltete D-Latches (3, 4, 5, 6) vorgesehen sind, die abwechselnd mit dem symmetrischen und dem invertierten symmetrischen Taktsignal getaktet werden,
   - die Ausgangssignale des letzten D-Latches (6) und des vorletzten D-Latches (5) einem NOR-Gatter (7) zugeführt werden,
   - der Ausgang des NOR-Gatters (7) dem Eingang des ersten D-Latches (3) und einer Ausgangsklemme (8) verbunden ist.

**Claims**

1. Circuit arrangement for generating a symmetrical output clock signal with odd division N of a symmetrical input clock signal,

   - having a first means for generating a first output signal from the symmetrical input clock signal, which begins with the respective Nth edge of the first type of the symmetrical clock signal and remains active for the duration of $\frac{N-1}{2}$ periods of the symmetrical clock signal,
   - having a second means for generating a second output signal from the symmetrical clock signal, which begins with the respective Nth edge of the other type of the symmetrical clock signal and remains active for the duration of $\frac{N-1}{2}$ periods of the symmetrical clock signal,
   - having a logic arrangement, which logically combines the two outward signals to form a symmetrical output clock signal,

   characterized in that

   - N+1 series-connected D latches (3, 4, 5, 6) are provided, which are alternately clocked by the symmetrical clock signal and the inverted symmetrical clock signal,
   - the output signals of the last D latch (6) and of the next-to-last D latch (5) are fed to a NOR gate (7),
   - the output of the NOR gate (7) is connected to the input of the first D latch (3) and to an output terminal (8).

**Revendications**

1. Circuit pour générer un signal de sortie d'horloge symétrique par un partage impair N d'un signal d'entrée d'horloge symétrique

   - avec un premier moyen pour la génération d'un premier signal de sortie à partir du signal d'entrée d'horloge symétrique qui commence avec à chaque fois le énième flanc du premier type du signal d'horloge symétrique et reste actif pour la durée de $\frac{N-1}{2}$ périodes du signal d'horloge symétrique,
   - avec un deuxième moyen pour la génération d'un deuxième signal de sortie à partir du signal d'horloge symétrique qui commence avec à chaque fois le énième flanc d'un autre type du signal d'horloge symétrique et reste actif pour la durée de $\frac{N-1}{2}$ périodes du signal d'horloge symétrique,
   - avec un dispositif logique qui associe les deux signaux de sortie en un signal de sortie d'horloge symétrique,

   **caractérisé en ce que**

   - N+1 verrous D (3, 4, 5, 6) commutés en série sont prévus, qui sont rythmés alternativement avec le signal d'horloge symétrique et le signal d'horloge symétrique inversé,
   - les signaux de sortie du dernier verrou D (6) et de l'avant dernier verrou D (5) sont conduits à une porte NOR (7),
   - la sortie de la porte NOR (7) est reliée à l'entrée du premier verrou D (3) et à une borne de sortie (8).

FIG 1

FIG 2